# FASCICULE DE BREVET EUROPEEN

(11) **EP 2 454 199 B1**
(45) Date de publication et mention de la délivrance du brevet: **15.11.2017**
(21) Numéro de dépôt: 10752010.8
(22) Date de dépôt: 13.07.2010
(51) Int. Cl.: C02F 1/28, C23C 14/04, C23C 16/04, A01N 25/08, A01N 25/34, C23C 14/18, C23C 14/22, C02F 1/00, C02F 103/04

(54) **Corps poreux de dépollution d'un fluide et procédé de son obtention**
Poröse Partikel zur Beseitigung von Schadstoffen aus einer Flüssigkeit und Verfahren zu seiner Herstellung
Porous particle for removing pollutants from a fluid and method for producing the particle

(30) Priorité: 13.07.2009 FR 0954861
(43) Date de publication de la demande: 23.05.2012
(73) Titulaire: Dioum, Serigne, 45100 Orléans (FR)
(72) Inventeur: Dioum, Serigne, 45100 Orléans (FR)
(74) Mandataire: Bonnet, Michel
(86) Numéro de dépôt international: PCT/FR2010/051478
(87) Numéro de publication internationale: WO 2011/007097

(56) Documents cités:
- EP-A1- 0 979 212
- WO-A1-98/50597
- WO-A1-2006/115486
- WO-A2-2006/128187
- CH-A5- 691 592
- US-A1- 2005 244 313
- US-B1- 6 197 120
- US-B1- 6 197 120
- US-B2- 6 878 419

## Description

La présente invention concerne un produit de dépollution d'un fluide. Elle concerne également un procédé d'obtention de ce produit.

On connaît des produits de dépollution de l'eau agissant par filtration. Les charbons actifs, les sables et autres corps poreux par exemple ont de très bonnes capacités de filtration résultant de leur importante surface spécifique externe et interne permettant une grande adsorption. Le principal inconvénient de ces produits résulte du fait qu'ils n'ont pas d'effet bactéricide ou au moins bactériostatique combiné à leur simple pouvoir filtrant mécanique. Au contraire, ils se révèlent même être de parfaits nids à bactéries et ne garantissent pas une potabilité de l'eau filtrée. Ils ne permettent donc pas de se passer de l'adjonction de désinfectants chimiques (chlore, peroxydes, etc.) dans le processus de traitement de l'eau.

On connaît aussi des produits de traitement bactéricide de l'eau constitués de charbon actif imprégné d'argent sous forme de sels. Ces produits de traitement sont notamment obtenus par immersion du charbon actif dans une solution de nitrates et autres sels d'argent. Un produit de ce type est par exemple divulgué dans le brevet publié sous le numéro FR 2 585 694. Ce produit comporte des inconvénients parce qu'un relargage d'argent et de nitrates dans l'eau traitée est inévitable : des nitrates restent présents dans le produit obtenu et l'argent ajouté selon ce procédé n'est lié au corps poreux que par des liaisons chimiques faibles de type liaisons de Van der Waals.

Par ailleurs, dans ce document FR 2 585 694 mais aussi dans le brevet publié sous le numéro US 4,407,865, il est prévu de métalliser du charbon actif avec de l'argent métal, à chaud, dans une enceinte à atmosphère inerte où un vide poussé est en outre éventuellement effectué. Dans cette enceinte, l'argent est évaporé pour pouvoir pénétrer le charbon. Ce procédé permet une bonne diffusion de l'argent dans les pores du charbon mais le mauvais accrochage de l'argent avec le carbone entraîne de nouveau un relargage d'argent dans l'eau traitée. En outre, le produit obtenu est plus friable et s'use au passage de l'eau. Cette application ne permet pas d'obtenir un produit stable et l'obtention de ce produit est difficile de façon industrielle.

Plus récemment, l'apport des nanotechnologies a permis d'envisager le développement de nanomatériaux, ou de matériaux dont au moins l'un des constituants est présent à l'échelle nanométrique, que des propriétés spécifiques et remarquables rendent particulièrement adaptés à des applications notamment dans la lutte pour la sauvegarde de l'environnement ou pour la dépollution. Dans le domaine du traitement des fluides, et de l'eau en particulier, des recherches ont apporté quelques évolutions tant dans le domaine de la filtration (ultrafiltration à travers des membranes de nouvelle génération) que dans celui du traitement bactéricide ou au moins bactériostatique des fluides, ou dans celui du traitement par dégradation des pollutions chimiques notamment par des nanoparticules métalliques.

Par exemple un filtre éliminateur de pesticide basé sur la chimie des nanoparticules a été développé à l'Institut Indien de Technologie IIT (de l'Anglais « Indian Institute of Technology ») de Chennai. Cette application résulte de l'observation que des hydrocarbures halogénés tels que le tétrachlorure de carbone se décomposent en halogénures métalliques et en carbone amorphe suite à des réactions avec de l'or et des nanoparticules d'argent. Mais ce filtre n'a pas d'effet bactéricide ou bactériostatique.

Par exemple également, l'unité Nano-Fotocide (marque déposée) dont la technologie a été développée par l'université de Hong-Kong base son principe de fonctionnement sur l'action d'un rayonnement ultraviolet à basse énergie et l'activation d'un dioxyde de titane agissant comme catalyseur sur sa surface en présence d'air ou d'eau pour générer des radicaux hydroxyles qui oxydent certains polluants comme les bactéries et les virus en donnant comme produit résultant de ces réactions du dioxyde de carbone et de l'eau. On notera cependant que cette réaction produisant du dioxyde de carbone n'est pas idéale à l'heure où ce gaz à effet de serre est l'objet de toutes les attentions visant à la réduction de ses émissions.

Enfin, des recherches sont actuellement en cours, notamment à l'université RICE de Houston aux Etats-Unis d'Amérique, sur les nanoparticules bimétalliques et leurs capacités à dégrader les aromates organiques et pesticides contenus dans les eaux souterraines sous l'action d'un rayonnement ultraviolet.

Par ailleurs, les procédés aujourd'hui mieux maîtrisés d'injection d'atomes métalliques sur des corps poreux en milieu plasma permettent de fournir des produits ne produisant plus de relargage métallique grâce à l'établissement de liens chimiques forts entre les atomes métalliques injectés et la surface spécifique du corps poreux.

On entend par « lien chimique fort », tout lien faisant intervenir une liaison chimique résultant de l'action de forces intramoléculaires : dans cette catégorie entrent les liens covalents (mise en commun d'un nuage d'électrons entre deux atomes), les liens ioniques (transfert d'au moins un électron d'un atome vers un autre), ou même des liens à niveaux d'énergie plus élevés d'un ou plusieurs électrons. Par opposition, un lien chimique faible résulte de l'action de forces intermoléculaires, autrement dit de forces d'interactions électriques de faible intensité entre atomes, molécules ou cristaux : dans cette catégorie entrent notamment les liens de type Van der Waals dans lesquels aucun électron n'est mis en commun entre atomes.

L'invention s'applique donc plus particulièrement à un produit du type précité comportant, d'une part, un corps poreux présentant une surface spécifique externe et interne et, d'autre part, une couche métallisée d'épaisseur au plus nanométrique recouvrant au moins une partie de la surface spécifique externe et interne du corps poreux, la couche métallisée comprenant au moins un métal lié au corps poreux par des liaisons chimiques résultant de l'action de forces intramoléculaires.

Un tel produit est divulgué dans le brevet publié sous le numéro EP 0 979 212. Ce produit présente un corps poreux et une couche métallique, uniformément répartie sur toute la surface spécifique externe et interne du corps poreux, dans laquelle les atomes de métal sont liés à la surface externe et interne du corps poreux par des liaisons covalentes. L'utilisation de ce produit pour le traitement d'un fluide tel que de l'eau valide son potentiel bactéricide.

Il peut être cependant souhaité de concevoir un produit de dépollution d'un fluide qui permette d'améliorer encore le traitement de ce fluide.

L'invention a donc pour objet un produit de dépollution d'un fluide, comportant, d'une part, un corps poreux comprenant un composant carboné et présentant une surface spécifique externe et interne et, d'autre part, une couche métallisée d'épaisseur au plus nanométrique recouvrant au moins une partie de la surface spécifique externe et interne du corps poreux, la couche métallisée comprenant au moins un métal lourd et du silicium liés au composant carboné du corps poreux par des liaisons chimiques résultant de l'action de forces intramoléculaires de manière à constituer des composants de type carbures de siliciures de métal. Le métal lourd est de masse atomique supérieure ou égale à celle du cuivre.

Il apparaît que l'ajout de silicium dans la couche métallisée lié au corps poreux par des liaisons fortes donne au produit de nouvelles propriétés inattendues, notamment en matière de rayonnement électromagnétique, de transfert d'énergie vers le fluide traité et de catalyse énergétique dans des processus de dégradation de polluants chimiques tels que certains hydrocarbures et autres pesticides, tout en conservant ses propriétés bactéricides.

De façon optionnelle, les carbures de siliciures de métal sont révélés à un niveau d'énergie sensiblement égal à 283 eV.

De façon optionnelle également, au moins une partie du silicium est également liée à au moins une partie du métal lourd de la couche métallisée par des liaisons chimiques résultant de l'action de forces intramoléculaires.

De façon optionnelle également, la couche métallisée comporte en outre des composants comprenant des atomes de carbone, silicium et métal lourd liés entre eux par des liaisons chimiques de type liaisons covalentes.

De façon optionnelle également, le corps poreux comprend au moins l'un des éléments de l'ensemble constitué d'une poudre de carbone, de graphite, de charbon actif, de sable et de zéolithe.

De façon optionnelle également, la couche métallisée recouvre partiellement la surface spécifique externe et interne du corps poreux par formation d'agrégats.

L'invention a également pour objet un procédé d'obtention d'un produit de dépollution d'un fluide, comportant une étape de traitement d'un corps poreux comprenant un composant carboné et présentant une surface spécifique externe et interne dans un réacteur de dépôt à plasma de gaz inerte et à décharge radiofréquence, ce réacteur de dépôt étant de type diode, d'une puissance électrique sensiblement égale à 10 kW, couplée à une boîte d'accord d'impédance de type RLC, par :
- immersion du corps poreux dans le plasma de gaz inerte avec une source de métal lourd de masse atomique supérieure ou égale à celle du cuivre et une source de silicium, puis
- injection de ce métal lourd et de ce silicium, dans le plasma de gaz inerte, sur au moins une partie de la surface spécifique externe et interne du corps poreux par bombardement d'ions de gaz inerte du plasma sur les sources de métal lourd et de silicium, de manière à former une couche métallisée d'épaisseur au plus nanométrique recouvrant ladite au moins une partie de la surface spécifique externe et interne du corps poreux, cette couche métallisée comportant ainsi, en interaction avec le corps poreux, des composants de type carbures de siliciures de métal dans lesquels le métal lourd et le silicium de la couche métallisée sont liés au composant carboné du corps poreux par des liaisons chimiques résultant de l'action de forces intramoléculaires,
dans lequel la température d'excitation du plasma est portée entre 5000 et 7000 K pendant l'étape de traitement.

L'invention a également pour objet un procédé d'obtention d'un produit de dépollution d'un fluide, comportant :
- une étape préalable de fonctionnalisation d'un corps poreux comprenant un composant carboné et présentant une surface spécifique externe et interne dans un réacteur à lit fluidisé jaillissant à basse pression, notamment comprise entre 5 et 500 Pa, à plasma froid de gaz inerte et à décharge inductive, puis
- une étape de traitement du corps poreux dans un réacteur de dépôt à plasma de gaz inerte et à décharge radiofréquence, par :
   - immersion du corps poreux dans le plasma de gaz inerte avec une source de métal lourd de masse atomique supérieure ou égale à celle du cuivre et une source de silicium, puis
   - injection de ce métal lourd et de ce silicium, dans le plasma de gaz inerte, sur au moins une partie de la surface spécifique externe et interne du corps poreux par bombardement d'ions de gaz inerte du plasma sur les sources de métal lourd et de silicium, de manière à former une couche métallisée d'épaisseur au plus nanométrique recouvrant ladite au moins une partie de la surface spécifique externe et interne du corps poreux, cette couche métallisée comportant ainsi, en interaction avec le corps poreux, des composants de type carbures de siliciures de métal dans lesquels le métal lourd et le silicium de la couche métallisée sont liés au composant carboné du corps poreux par des liaisons chimiques résultant de l'action de forces intramoléculaires.

L'invention sera mieux comprise à l'aide de la description qui va suivre, donnée uniquement à titre d'exemple et faite en se référant aux dessins annexés dans lesquels :
- la figure 1 représente schématiquement la structure d'une portion de produit de dépollution de fluide selon l'invention,
- la figure 2 représente schématiquement la structure générale d'une installation de mise en oeuvre d'un procédé d'obtention du produit de la figure 1, et
- les figures 3 et 4 représentent, sous forme de diagrammes, des niveaux énergétiques mesurés de fluides traités ou non par une unité de filtration comportant un produit selon l'invention.

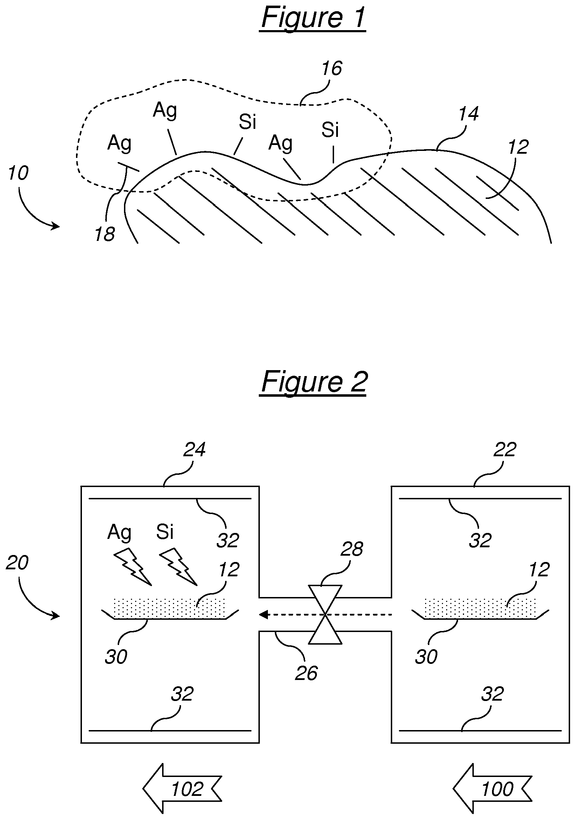

Le produit 10 de dépollution d'un fluide représenté partiellement et schématiquement sur la figure 1 comporte un corps poreux 12 présentant une surface spécifique externe et interne 14 d'une surface telle qu'elle lui procure un pouvoir filtrant important. Dans un mode de réalisation préféré de l'invention, le corps poreux comporte un composant carboné tel que de la poudre ou des granulés de carbone, par exemple de granulométrie moyenne comprise entre 0,5 et 1 mm, du graphite sous forme de feuille ou de barre, du charbon actif, des tissus ou fibres de carbone activé ou une combinaison de ces éléments. Il peut en outre comporter d'autres composants, notamment des composant comprenant du silicium, tels que des sables ou de la zéolithe. Sans traitement particulier, ce corps poreux présente déjà des vertus filtrantes mais pas bactéricides ou bactériostatiques.

Suite à un traitement tel que par exemple celui qui sera détaillé en référence à la figure 2, le produit 10 comporte en outre une couche métallisée 16 d'épaisseur au plus nanométrique recouvrant au moins une partie de la surface spécifique externe et interne 14 du corps poreux 12. On entend par « épaisseur au plus nanométrique » une épaisseur ne dépassant pas quelques nanomètres, voire restant pour l'essentiel dans des dimensions inférieures au nanomètre.

La couche métallisée comporte du métal, par exemple de l'argent, mais aussi du silicium. Les atomes Ag et Si de ces composants sont liés au corps poreux 12 par des liaisons chimiques fortes, c'est-à-dire selon la définition qui en a été donnée précédemment, par des liaisons chimiques résultant de l'action de forces intramoléculaires. Certains atomes d'argent Ag et de silicium Si de la couche métallisée 16 peuvent aussi être liés entre eux par des liaisons chimiques résultant de l'action de forces intramoléculaires.

Le produit illustré sur la figure 1, fourni à titre d'exemple non limitatif, présente une couche métallisée à l'aide d'argent mais tout autre métal lourd ou combinaison de métaux lourds (des bimétaux par exemple), incluant notamment de l'or, du cuivre et du zinc, convient également. Plus généralement, on entend par « métal lourd », tout métal de masse atomique supérieure ou égale à celle du cuivre. Du nickel conviendrait aussi : ce dernier est généralement considéré comme allergisant et cancérigène, mais dans le produit 10, il serait présent en quantité tellement infime qu'il n'aurait pas ces effets nocifs.

Ainsi constitué, le produit 10 est principalement composé de carbone et comporte en quantité très faible du silicium et un métal lourd présent de préférence sous une forme très pure. La pureté du métal est par exemple de l'ordre de N6, c'est-à-dire égale à 99,9999 %. En outre, le procédé d'obtention de ce produit qui sera détaillé en référence à la figure 2 permet le dépôt d'une couche métallisée à liaisons chimiques fortes incluant le métal sous forme non oxydée (forme Ag° dans le cas où de l'argent est utilisé).

Cette couche métallisée à l'aide d'argent et à liaisons chimiques fortes entre l'argent, le silicium et le corps poreux confère au produit 10 une propriété bactéricide par catalyse énergétique de réactions d'oxydation, ou au moins une propriété bactériostatique.

Par application du procédé d'obtention qui sera décrit en référence à la figure 2, la couche métallisée 16 comporte avantageusement, en interaction avec le corps poreux 12, des composants de type carbures de siliciures de métal, notamment révélés par un niveau d'énergie sensiblement égal à 283 eV. L'obtention de ces composants de structure moléculaire très stable et donc solide indique que les liaisons chimiques entre le métal, le silicium et le corps poreux (notamment l'élément carbone du corps poreux) sont très fortes, en particulier plus fortes que des liaisons covalentes ou ioniques. Ainsi, le produit 10 ne risque pas de perdre l'un de ses constituants lors d'une utilisation dans le traitement d'un fluide comme de l'eau par exemple et, ne comportant pas de risque de relargage de nanoparticules bien que sa couche métallisée soit d'épaisseur nanométrique, il se trouve tout a fait adapté aux applications de potabilisation et autres industries agroalimentaires nécessitant la purification de fluides.

La couche métallisée 16 peut en outre comporter des composants comprenant des atomes de carbone, silicium et métal liés entre eux par des liaisons chimiques de type liaisons covalentes.

Enfin, dans un mode de réalisation préféré, la couche métallisée 16 ne recouvre que partiellement la surface spécifique externe et interne 14 du corps poreux 12 par formation d'agrégats. De cette façon, les pores (notamment les micropores) du corps poreux, où les sites actifs peuvent participer aux échanges ioniques, adsorption et réactions catalytiques, ne sont pas complètement bouchés par la couche métallisée 16.

L'installation 20 représentée sur la figure 2 est adaptée pour la mise en oeuvre d'un procédé d'obtention du produit 10 précédemment décrit. L'illustration n'étant que schématique, elle n'est pas à prendre en compte pour ses proportions.

Elle comporte un premier réacteur de fonctionnalisation à plasma 22 relié à un second réacteur 24 de dépôt par plasma hors équilibre par un conduit 26 muni d'un système de transfert comportant notamment une vanne 28. La commande de ce système de transfert et de cette vanne 28 permet le passage d'un plateau 30 de l'intérieur du premier réacteur 22 vers l'intérieur du second réacteur 24. Dans chaque réacteur, un milieu plasma est engendré entre des électrodes 32 et le corps poreux 10, disposé sur le plateau 30, est immergé dans ce plasma.

Plus précisément, selon un procédé d'obtention du produit 10, au cours d'une première étape de fonctionnalisation 100, le corps poreux 12 est immergé dans le plasma du premier réacteur 22. Ce réacteur 22 est à lit fluidisé jaillissant à basse pression, de préférence une pression comprise entre 5 et 500 Pa, à plasma froid de gaz inerte et à décharge inductive. Le gaz inerte employé est par exemple de l'argon. Pendant cette première étape 100, le corps poreux 12 est bombardé d'ions d'argon, ce qui a pour effet, tout d'abord, de le débarrasser d'impuretés, mais aussi de développer sa surface active par augmentation de sa surface spécifique externe et interne et création de sites d'ancrage.

Les paramètres de fonctionnement de l'étape 100 peuvent être les suivants :
- débit d'argon : variable et dépendant du type de matériau utilisé,
- pression dans le réacteur : entre 5 et 500 Pa,
- température dans le réacteur : température classique en milieu de plasma froid,
- puissance d'excitation du plasma : entre 100 et 400 W, par exemple 400 W, et
- durée de l'étape de fonctionnalisation : 5 mn.

Au cours d'une seconde étape de dépôt 102, le corps poreux 12 est immergé dans le plasma du second réacteur 24, par exemple par ouverture de la vanne 28 et commande du système de transfert, c'est-à-dire par déplacement du plateau 30 à travers le conduit 26. Ce réacteur 24 est de type diode, d'une puissance électrique sensiblement égale à 10 kW, couplée à une boîte d'accord d'impédance de type RLC, à plasma chaud de gaz inerte et à décharge radiofréquence. Le gaz inerte employé est par exemple également de l'argon. Ce réacteur de dépôt 24 comporte en outre des sources d'argent et de silicium. La source d'argent comporte par exemple un ou plusieurs fils d'argent, ou une plaque ou feuille d'argent, dimensionnés pour ne pas perturber le milieu plasma engendré dans le réacteur 24. La source de silicium comporte par exemple une plaque ou un morceau de quartz de taille et de forme également choisies pour ne pas perturber le milieu plasma.

En variante, la source de silicium peut provenir du corps poreux 12 lui-même, si celui-ci en contient, notamment lorsqu'il comporte du sable ou de la zéolithe. Par exemple, le corps poreux peut être constitué d'une combinaison de charbon actif et de zéolithe. La zéolithe est, du point de vue de sa structure complexe, un polymère inorganique cristallin basé sur une suite tridimensionnelle de structures quadri-connectées de AlO₄ et de SiO₄ tétraédriques liées entre elles par un échange d'ions d'oxygène. L'étape de fonctionnalisation 100 pratiquée sur une telle combinaison permet d'allier les macropores du carbone aux micropores ordonnés de la zéolithe en les tapissant en couche mince. Les macropores du carbone permettent un accès facilité aux micropores de la zéolythe où les sites actifs peuvent participer aux échanges ioniques, à l'adsorption et aux réactions catalytiques.

Pendant la seconde étape 102, les sources d'argent et de silicium sont bombardées d'ions d'argon sous une température du plasma comprise entre 5000 et 7000 K, ce qui a pour effet de provoquer une injection d'atomes d'argent et de silicium, dans le plasma d'argon, sur au moins une partie de la surface spécifique externe et interne du corps poreux 12 de manière à former une couche métallisée d'épaisseur au plus nanométrique liée au corps poreux par la formation de carbures de siliciures d'argent et également de sous-produits liés de manière covalente combinant le carbone, l'argent et le silicium. Cette couche prend avantageusement la forme d'agrégats qui ne bouchent pas les pores du corps poreux 12, même s'il est possible de régler les paramètres de traitement de l'étape 102 pour obtenir une couche plus uniforme. La durée de cette étape 102 est réglable mais est avantageusement inférieure à 5 mn pour l'obtention d'une couche métallisée sous forme d'agrégats d'épaisseur au plus nanométrique. L'espace entre les électrodes 32 du second réacteur 24 est par exemple d'environ 4 cm de sorte qu'il permet d'établir un champ électrique très élevé dans le plasma, d'où une grande modularité de l'intensité du flux d'ions d'argon et une fonctionnalisation de surface optimale du corps poreux 12. Cette seconde étape 102 permet aussi de développer la surface active du produit 10 par augmentation de sa surface spécifique externe et interne.

Les paramètres de fonctionnement de l'étape 102 peuvent être les suivants :
- débit d'argon : environ 40 sccm (cm³ par minute),
- pression dans le réacteur : environ 0,01 Pa,
- température d'excitation plasma dans le réacteur : entre 5000 et 7000 K, notamment 6000 K,
- puissance d'excitation du plasma : 1,5 kW,
- fréquence de la décharge radiofréquence : 13,56 MHz,
- tension d'autopolarisation : au moins 1,2.10⁵ V/m,
- durée de l'étape de dépôt : 3 mn, et
- épaisseur déposée : entre 5 et 10 angstrôm.

Dans ces conditions, on obtient une très grande densité d'atomes d'Argon se trouvant dans l'état d'excitation métastable ³P₂ conférant une forte énergie de désexcitation au contact du corps poreux 12. Le taux de matière injectée est évalué à 7,5µg/s.

La caractérisation par spectrométrie de photoélectrons X du produit 10 obtenu permet notamment de révéler le pic énergétique du carbure de siliciure d'argent à 283 eV, mais aussi d'autres énergies de liaison relatives au carbone, au silicium et à l'argent ainsi que différents autres états oxydés en très faible quantité qui sont bénéfiques aux mécanismes de dépollution chimique et autres oxydations des bactéries et virus rencontrés dans le traitement des fluides.

Le produit 10 obtenu selon l'invention et fonctionnalisé en un seul et même procédé intégré tel que celui décrit précédemment, avec un matériau de type charbon actif, a été testé et analysé dans le cas du traitement de l'eau. Il apparaît que le traitement bactéricide est bien vérifié mais également la catalyse des processus de dégradation de polluants chimiques tels que certains hydrocarbures et autres pesticides, comme le DDT (i.e. le DichloroDiphénylTrichloroéthane) par exemple. En outre, on observe que la présence de silicium sous forme de carbure développe les propriétés électriques du produit.

### CONDITIONS EXPERIMENTALES DU TEST

Une unité de filtration comportant un premier filtre d'épaisseur et un deuxième filtre à charbon comportant le produit de traitement 10, a été installée en laboratoire pour déterminer son efficacité à contrôler un certain nombre de pathogènes humains contenus dans l'eau. Le fonctionnement de l'unité s'est effectué dans un module de sécurité de classe III en utilisant l'eau brute de la Tamise comme source d'approvisionnement en eau.

Le matériel utilisé pour le test comportait plus précisément les éléments suivants :
- un cabinet d'étanchéité de Classe III,
- une pompe Watson Marlow, série 800 (marque déposée),
- des tubes pressurisés,
- 50 litres d'eau de la Tamise,
- deux containers Nalgene (marque déposée) de 50 litres stériles,
- un premier filtre d'épaisseur (0.2µ),
- un filtre à charbon comportant le produit 10,
- des plateaux de gélose (BCYE, YEA).

Les micro-organismes utilisés ont été les suivants :
- Pseudomonas diminuta : l'une des plus petites bactéries aquatiques, souvent utilisée pour tester les filtres du fait qu'elle est le plus probable organisme à pénétrer un système de filtration,
- Escherichia coli : indicateur particulièrement important de contamination fécale,
- Pseudomonas aeruginosa : une bactérie opportuniste chez les patients immuno-déficients,
- Legionella pneumophila serogroup 1 Pontiac : un agent bactérien responsable de la maladie du Légionnaire, qui prolifère dans les systèmes d'eau chaude et froide des immeubles ainsi que dans les cheminées de refroidissement, et
- Cryptosporidium parvum : un protozoaire parasite constituant un problème majeur pour l'industrie de l'eau à cause de sa résistance au chlore, le désinfectant le plus communément utilisé.

La source microbienne a été cultivée sur un média approprié de gélose incubé à 37°C pendant une nuit, puis ajoutée séparément à l'eau du test afin d'obtenir une inoculation de 10² à 10⁶ par ml pour chaque micro-organisme. Le Cryptosporidium parvum a été ajouté pour obtenir une quantité de 10⁴ à 10⁵ par ml.

L'unité de filtration a été mise en circulation en boucle pendant au moins trente minutes pour conditionner l'unité avant de procéder au test. L'eau contenant l'inoculum bactérien a ensuite été introduite dans le filtre à un débit de 4,15 l/mn afin de déterminer l'efficacité de l'unité de filtration à réduire la charge bactérienne.

Des dilutions en séries du premier filtre ont été conduites pour déterminer le nombre effectif de bactéries (colonies formant des unités par ml) entrant et passant par l'unité de filtration.

Des échantillons de l'eau filtrée (100 ml) ont été concentrés par filtration.

Pour l'analyse de la Legionella, les échantillons ont été cultivés sur un média de gélose BCYE. Les échantillons de Pseudomonas diminuta, Pseudomonas aeruginosa, et Escherichia coli ont été cultivés sur des média de gélose appropriés (YEA).

Un échantillon d'eau de post-filtration de chaque test a été conservé et recultivé quinze jours après, afin de déterminer si un redéveloppement avait eu lieu.

Un aliquot (10 ml) d'eau de post-filtration a immédiatement été mélangé à 10 ml d'eau de pré-filtration et le nombre d'organismes cultivables immédiatement déterminé à 5 mn et à 15 jours.

Le pourcentage de viabilité des oocytes Cryptosporidium parvum dans les échantillons d'eau de pré- et post-filtration a été déterminé par contamination vitale en utilisant du propidium et du 4'-6' diamidino 2-phenylindole. Les résultats ont été obtenus par examen microscopique en utilisant la microscopie fluorescente.

Le nombre d'oocytes Cryptosporidium parvum par ml dans les échantillons de pré- et post-traitement d'eau a été déterminé par contamination d'anticorps monoclonaux de Cryptosporidium marqués de fluorescence. Le nombre d'oocytes présents a été compté par utilisation de la microscopie fluorescente.

Enfin, l'équipement a été fumigé au formaldéhyde, et de l'eau chaude (60°C) a été passée à l'intérieur de l'unité de filtration pour désactiver le Cryptosporidium parvum.

### RESULTATS DU TEST ET DISCUSSION

L'unité de filtration testée a enlevé plus de 99,9 % de toutes les espèces bactériennes testées. Il y a eu une réduction de 100% du nombre des Escherichia coli et Legionella pneumophila et aucune bactérie n'a été retrouvée après traitement. Ceci s'est trouvé confirmé lorsque 100 ml de l'eau de post-filtration ont été concentrés et analysés pour la présence de bactéries. Le simple passage de l'eau par l'unité de filtration à un débit de 4,15 l/mn en utilisant de l'eau de la Tamise suggère que cette unité de filtration réduirait de plus de 99,9 % la présence de bactéries pathogènes contenues dans l'eau.

Les échantillons d'eau de Post-filtration ont été conservés pendant 15 jours et ont démontré qu'aucun redéveloppement n'a eu lieu dans les échantillons d'eau filtrés.

Des bactéries ont été ajoutées à l'eau de post-filtration afin de déterminer l'efficacité bactéricide résiduelle. Les résultats indiquent qu'une réduction de 10 à 20 % a été obtenue dans les 5 mn ; toutefois, après 15 jours, une réduction supérieure à 95 % a été constatée. Les résultats indiqueraient donc que l'eau de post-filtration ne serait pas capable de maîtriser rapidement une re-contamination par les bactéries utilisées dans ce test.

Le protozoaire Cryptosporidium parvum est particulièrement résistant aux traitements désinfectants. Cependant, il y a eu une réduction notable (plus de 95 %) du nombre de Cryptosporidium parvum passant par l'unité de filtration.

On notera en outre que ce test permet de mettre en évidence les propriétés décontaminantes de l'unité de filtration comportant le produit 10 mais également de mettre en évidence une propriété très singulière qui est la rémanence du traitement de décontamination. La rémanence est ce que l'on peut définir comme la persistance d'un phénomène quand la cause de ce phénomène a disparu. Dans le cas du traitement bactéricide testé, le fluide traité conserve (parfois plusieurs semaines selon les conditions expérimentales) son pouvoir décontaminant assurant une protection sanitaire de l'eau sans ajout d'aucun produit chimique supplémentaire tel le chlore ou autre. L'étude et la caractérisation de cette rémanence conduisent à déterminer les différents paramètres influant sur le procédé de traitement à mettre en oeuvre telle l'énergie cinétique de l'eau traversant l'unité de filtration, sa charge minérale, etc.

Par ailleurs, en s'intéressant au paramètre de température de l'eau avant et après traitement par l'unité de filtration, le caractère endothermique des réactions catalytiques après traitement peut être mis en évidence puisque une eau brute initialement à 26°C avec une température ambiante de 27°C ressort de l'unité de filtration à 18°C et reste constante à 19°C plusieurs heures après, même en la laissant à l'air libre dans le même milieu ambiant à température constante, ce qui traduit une variation d'enthalpie positive.

Enfin, l'observation de phénomènes électrostatiques sur le produit 10 conduit à s'intéresser à l'étude de la dynamique des champs électriques qui sont très faibles dans les fluides traités, à l'aide d'un appareil tel que le « Bioscope System » (marque déposée) commercialisé par la société Sonoscope. Cet appareil dont le principe est basé sur l'électro-bio-impédance permet de détecter et d'enregistrer de subtiles variations de champs électro-acoustiques communs à tout environnement bioactif. L'appareil, génère à une fréquence audio, non acoustique, un signal de référence qui est utilisé pour régler un champ électrique extensible. Ce signal de référence est transmis par l'intermédiaire d'une électrode transductrice à l'échantillon à analyser. Un signal de référence est établi entre l'appareil et l'échantillon en cours de numérisation. Quand un matériau est en contact avec le milieu, il produit une perturbation qui à son tour modifie le signal de référence.

Cet appareil permet de mettre en évidence de subtiles variations d'état qui ne peuvent pas être détectés par des analyses chimiques. Il permet ainsi de visualiser très rapidement les changements de paramètres, y compris les changements de qualité et la contamination éventuelle, de l'eau traitée.

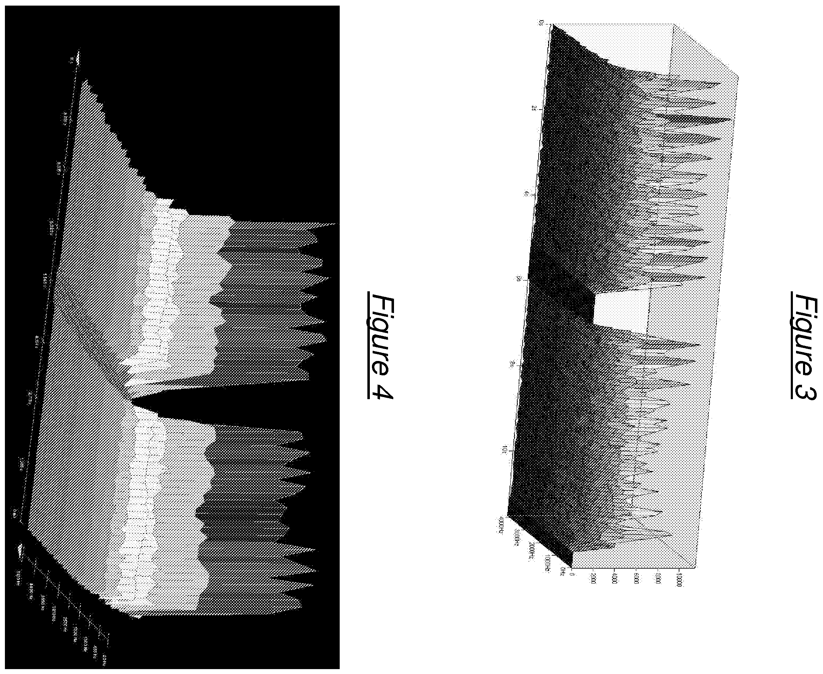

La figure 3 illustre à l'aide d'un diagramme la nette différence de niveaux énergétiques, pour une même fréquence d'excitation (281,25 Hz) et un débit de prélèvement identique, entre une eau traitée par le produit 10 (diagramme de gauche) et cette même eau non traitée (diagramme de droite). Ce diagramme donne l'évolution au cours du temps du spectre, entre 0 et 4000 Hz, d'une onde renvoyée par le milieu correspondant (l'eau traitée à gauche et l'eau non traitée à droite) en réponse à l'onde d'excitation.

Par ailleurs, les effets électromagnétiques, donc énergétiques du produit 10 sont ressentis par le fluide traité même lorsque ce dernier n'est pas directement en contact avec le produit comme en témoignent les spectres suivants de la figure 4. Sur cette figure, les différences d'énergie entre une eau traitée par le produit 10 (diagramme de gauche) et cette même eau non traitée (diagramme de droite) mais prélevée à proximité de l'unité de filtration comportant le produit 10 sont nettement moins importantes.

Les phénomènes électrostatiques observés sont donc vérifiés et permettent de montrer que l'unité de filtration testée a une action de dynamisation énergétique sur le fluide à traiter, même sans contact direct lorsque le fluide reste à proximité du produit 10. Ces propriétés électriques proviennent de la présence de carbure de siliciure de métal.

Cette dynamique énergétique se traduit au niveau cellulaire, lorsque l'on introduit différentes proportions d'eau dans un milieu de culture cellulaire et lorsque l'on mesure l'absorbance de protéine. En effet, une étude comparée de l'effet d'une eau non traitée et de la même eau traitée à l'aide du produit 10 a été effectuée sur des fibroblastes en culture (entre 20 et 50% dans le milieu de culture). Des mesures ont été prises dans les surnageants, après 48 heures de traitement. Il en résulte que l'introduction d'une eau traitée à l'aide du produit 10 permet de monter à plus de 50% en proportion du milieu de culture quand une eau non traitée ne permet pas d'atteindre 10% sans que les cellules ne meurent. L'augmentation de la proportion en eau appauvrissant le milieu nutritif, il est donc évident que la biodisponibilité du milieu est nettement améliorée avec l'eau traitée. Cela se traduit également par le constat d'une meilleure croissance cellulaire avec l'eau traitée.

Il apparaît clairement qu'un produit de dépollution selon l'invention, et en particulier celui décrit et testé précédemment présente un bon pouvoir catalytique dans des réactions bactéricides de fluides tels que de l'eau, de l'air ou d'autres fluides industriels. Comme le montrent les tests réalisés, il présente en outre des propriétés étonnantes de rémanence de l'effet bactéricide pendant plusieurs semaines sur le fluide traité et d'amélioration de la biodisponibilité du fluide traité en dynamisant notamment son énergie. Enfin, il produit un effet à distance sans contact direct sur le fluide par rayonnement électromagnétique.

Le procédé d'obtention de ce produit de dépollution décrit en référence à la figure 2 permet par ailleurs d'augmenter assez considérablement la surface spécifique du produit final améliorant ainsi sa capacité d'adsorption et donc de filtration, comme cela a été précisé dans la description des étapes de fonctionnalisation et de dépôt 100 et 102.

On notera par ailleurs que l'invention n'est pas limitée au mode de réalisation décrit précédemment. D'autres métaux, notamment des métaux lourds, que l'argent peuvent être utilisés pour métalliser la couche d'épaisseur au plus nanométrique.

Il apparaîtra plus généralement à l'homme de l'art que diverses modifications peuvent être apportées au mode de réalisation décrit ci-dessus, à la lumière de l'enseignement qui vient de lui être divulgué. Dans les revendications qui suivent, les termes utilisés ne doivent pas être interprétés comme limitant les revendications au mode de réalisation exposé dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué. L'invention est définie par les revendications annexées.

## Revendications

1. Produit (10) de dépollution d'un fluide, comportant, d'une part, un corps poreux (12) comprenant un composant carboné et présentant une surface spécifique externe et interne (14) et, d'autre part, une couche métallisée (16) d'épaisseur au plus nanométrique recouvrant au moins une partie de la surface spécifique externe et interne (14) du corps poreux (12), la couche métallisée (16) comprenant au moins un métal lourd de masse atomique supérieure ou égale à celle du cuivre et du silicium, le métal lourd et le silicium de la couche métallisée étant liés au composant carboné du corps poreux (12) par des liaisons chimiques (18) résultant de l'action de forces intramoléculaires de manière à constituer des composants de type carbures de siliciures de métal.

2. Produit de dépollution d'un fluide selon la revendication 1, dans lequel les carbures de siliciures de métal qu'il comporte sont des composants de type révélés à un niveau d'énergie sensiblement égal à 283 eV.

3. Produit de dépollution d'un fluide selon la revendication 1 ou 2, dans lequel au moins une partie du silicium (Si) est également liée à au moins une partie du métal lourd de la couche métallisée (16) par des liaisons chimiques (18) résultant de l'action de forces intramoléculaires.

4. Produit de dépollution d'un fluide selon la revendication 3, dans lequel la couche métallisée (16) comporte en outre des composants comprenant des atomes de carbone, silicium et métal lourd liés entre eux par des liaisons chimiques de type liaisons covalentes.

5. Produit de dépollution d'un fluide selon l'une quelconque des revendications 1 à 4, dans lequel le corps poreux (12) comprend au moins l'un des éléments de l'ensemble constitué d'une poudre de carbone, de graphite, de charbon actif, de sable et de zéolithe.

6. Produit de dépollution d'un fluide selon l'une quelconque des revendications 1 à 5, dans lequel la couche métallisée (16) recouvre partiellement la surface spécifique externe et interne (14) du corps poreux (12) par formation d'agrégats.

7. Procédé d'obtention d'un produit (10) de dépollution d'un fluide, comportant une étape (102) de traitement d'un corps poreux (12) comprenant un composant carboné et présentant une surface spécifique externe et interne (14) dans un réacteur (24) de dépôt à plasma de gaz inerte et à décharge radiofréquence, ce réacteur de dépôt (24) étant de type diode, d'une puissance électrique sensiblement égale à 10 kW, couplée à une boîte d'accord d'impédance de type RLC, par :
- immersion du corps poreux (12) dans le plasma de gaz inerte avec une source de métal lourd de masse atomique supérieure ou égale à celle du cuivre et une source de silicium, puis
- injection de ce métal lourd et de ce silicium, dans le plasma de gaz inerte, sur au moins une partie de la surface spécifique externe et interne (14) du corps poreux (12) par bombardement d'ions de gaz inerte du plasma sur les sources de métal lourd et de silicium, de manière à former une couche métallisée (16) d'épaisseur au plus nanométrique recouvrant ladite au moins une partie de la surface spécifique externe et interne (14) du corps poreux (12), cette couche métallisée (16) comportant ainsi, en interaction avec le corps poreux, des composants de type carbures de siliciures de métal dans lesquels le métal lourd et le silicium de la couche métallisée sont liés au composant carboné du corps poreux (12) par des liaisons chimiques (18) résultant de l'action de forces intramoléculaires,
dans lequel la température d'excitation du plasma est portée entre 5000 et 7000 K pendant l'étape de traitement (102).

8. Procédé d'obtention d'un produit (10) de dépollution d'un fluide, comportant :
- une étape préalable (100) de fonctionnalisation d'un corps poreux (12) comprenant un composant carboné et présentant une surface spécifique externe et interne (14) dans un réacteur (22) à lit fluidisé jaillissant à basse pression, notamment comprise entre 5 et 500 Pa, à plasma froid de gaz inerte et à décharge inductive, puis
- une étape (102) de traitement du corps poreux (12) dans un réacteur (24) de dépôt à plasma de gaz inerte et à décharge radiofréquence, par :
• immersion du corps poreux (12) dans le plasma de gaz inerte avec une source de métal lourd de masse atomique supérieure ou égale à celle du cuivre et une source de silicium, puis
• injection de ce métal lourd et de ce silicium, dans le plasma de gaz inerte, sur au moins une partie de la surface spécifique externe et interne (14) du corps poreux (12) par bombardement d'ions de gaz inerte du plasma sur les sources de métal lourd et de silicium, de manière à former une couche métallisée (16) d'épaisseur au plus nanométrique recouvrant ladite au moins une partie de la surface spécifique externe et interne (14) du corps poreux (12), cette couche métallisée (16) comportant ainsi, en interaction avec le corps poreux, des composants de type carbures de siliciures de métal dans lesquels le métal lourd et le silicium de la couche métallisée sont liés au composant carboné du corps poreux (12) par des liaisons chimiques (18) résultant de l'action de forces intramoléculaires.

## Patentansprüche

1. Produkt (10) zur Beseitigung von Schadstoffen aus einer Flüssigkeit, umfassend, einerseits, einen porösen Körper (12), der eine kohlenstoffhaltige Komponente enthält und eine spezifische äußere und innere Oberfläche (14) aufweist, und, andererseits, eine metallisierte Schicht (16) mit einer höchstens nanometrischen Dicke, die mindestens einen Teil der spezifischen äußeren und inneren Oberfläche (14) des porösen Körpers (12) bedeckt, wobei die metallisierte Schicht (16) mindestens ein Schwermetall mit einer Atommasse, die höher oder gleich derjenigen von Kupfer ist, und Silicium enthält, wobei das Schwermetall und das Silicium der metallisierten Schicht an die kohlenstoffhaltigen Komponente des porösen Körpers (12) durch chemische Bindungen (18) gebunden sind, die sich aus der Wirkung von intramolekularen Kräften ergeben, um karbidartige Komponenten von Metallsiliciden darzustellen.

2. Produkt zur Beseitigung von Schadstoffen aus einer Flüssigkeit nach Anspruch 1, wobei die Karbide von Metallsiliciden, die es umfasst, Komponenten der Art sind, die auf ein Energieniveau von im Wesentlichen gleich 283 eV angehoben sind.

3. Produkt zur Beseitigung von Schadstoffen aus einer Flüssigkeit nach Anspruch 1 oder 2, wobei mindestens ein Teil des Siliciums (Si) auch an mindestens einen Teil des Schwermetalls der metallisierten Schicht (16) durch chemische Bindungen (18) gebunden ist, die sich aus der Wirkung von intramolekularen Kräften ergeben.

4. Produkt zur Beseitigung von Schadstoffen aus einer Flüssigkeit nach Anspruch 3, wobei die metallisierte Schicht (16) außerdem Komponenten umfasst, die Kohlenstoffatome, Silicium und Schwermetall enthalten, die untereinander durch chemische Bindungen der Art kovalente Bindungen gebunden sind.

5. Produkt zur Beseitigung von Schadstoffen aus einer Flüssigkeit nach einem der Ansprüche 1 bis 4, wobei der poröse Körper (12) mindestens eines der Elemente der Einheit enthält, die aus einem Kohlenstoffpulver, Graphit, Aktivkohle, Sand und Zeolith besteht.

6. Produkt zur Beseitigung von Schadstoffen aus einer Flüssigkeit nach einem der Ansprüche 1 bis 5, wobei die metallisierte Schicht (16) teilweise die spezifische äußere und innere Oberfläche (14) des porösen Körpers (12) durch Bildung von Aggregaten bedeckt.

7. Verfahren zum Erhalt eines Produkts (10) zur Beseitigung von Schadstoffen aus einer Flüssigkeit, umfassend einen Schritt (102) des Behandelns eines porösen Körpers (12), der eine kohlenstoffhaltige Komponente enthält und eine spezifische äußere und innere Oberfläche (14) aufweist, in einem Plasmaabscheidungsreaktor (24) von inertem Gas und mit Funkfrequenzentladung, wobei dieser Abscheidungsreaktor (24) der Art Diode ist, mit einer elektrischen Leistung, die im Wesentlichen gleich 10 kW ist, gekoppelt an ein Gehäuse zum Impedanzanpassen der Art RLC durch:
- Eintauchen des porösen Körpers (12) in das Plasma von inertem Gas mit einer Schwermetallquelle mit einer Atommasse, die höher oder gleich derjenigen des Kupfers ist, und einer Siliciumquelle, dann
- Injizieren dieses Schwermetalls und dieses Siliciums in das Plasma aus inertem Gas auf mindestens einem Teil der spezifischen äußeren und inneren Oberfläche (14) des porösen Körpers (12) durch Beschuss mit Ionen von inertem Gas des Plasmas auf die Schwermetall- und Siliciumquellen, um eine metallisierte Schicht (16) mit einer höchstens nanometrischen Dicke zu bilden, die den mindestens einen Teil der spezifischen äußeren und inneren Oberfläche (14) des porösen Körpers (12) bedeckt, wobei diese metallisierte Schicht (16) somit, in Wechselwirkung mit dem porösen Körper, karbidartige Komponenten von Metallsiliciden umfasst, in denen das Schwermetall und das Silicium der metallisierten Schicht an die kohlenstoffhaltige Komponente des porösen Körpers (12) durch chemische Bindungen (18) gebunden sind, die sich aus der Wirkung von intramolekularen Kräften ergeben,
wobei die Erregungstemperatur des Plasmas während des Schritts des Behandelns (102) auf zwischen 5000 und 7000 K gebracht wird.

8. Verfahren zum Erhalt eines Produkts (10) zur Beseitigung von Schadstoffen aus einer Flüssigkeit, umfassend:
- einen vorherigen Schritt (100) der Funktionalisierung eines porösen Körpers (12), enthaltend eine kohlenstoffhaltige Komponente und aufweisend eine spezifische äußere und innere Oberfläche (14) in einem Reaktor (22) mit sprudelndem Fließbett mit niedrigem Druck, insbesondere im Bereich zwischen 5 und 500 Pa, mit kaltem Plasmas von inertem Gas und induktiver Entladung, dann
- einen Schritt (102) des Behandelns des porösen Körpers (12) in einem Plasmaabscheidungsreaktor (24) von inertem Gas und mit Funkfrequenzentladung durch:
• Eintauchen des porösen Körpers (12) in das Plasma aus inertem Gas mit einer Schwermetallquelle mit einer Atommasse, die höher oder gleich derjenigen des Kupfers ist, und eine Siliciumquelle, dann
• Injizieren dieses Schwermetalls und dieses Siliciums in das Plasma aus inertem Gas auf mindestens einem Teil der spezifischen äußeren und inneren Oberfläche (14) des porösen Körpers (12) durch Beschuss mit Ionen von inertem Gas des Plasmas auf die Schwermetall- und Siliciumquellen, um eine metallisierte Schicht (16) mit einer höchstens nanometrischen Dicke zu bilden, die den mindestens einen Teil der spezifischen äußeren und inneren Oberfläche (14) des porösen Körpers (12) bedeckt, wobei diese metallisierte Schicht (16) somit, in Wechselwirkung mit dem porösen Körper, karbidartige Komponenten von Metallsiliciden umfasst, in denen das Schwermetall und das Silicium der metallisierten Schicht an die kohlenstoffhaltige Komponente des porösen Körpers (12) durch chemische Bindungen (18) gebunden sind, die sich aus der Wirkung von intramolekularen Kräften ergeben.

## Claims

1. Product (10) for removing pollutants from a fluid, comprising, on the one hand, a porous body (12) including a carbonaceous component and having an outer and inner specific surface (14) and, on the other hand, a metallized layer (16), the thickness of which is at most nanoscale, covering at least part of the outer and inner specific surface (14) of the porous body (12), the metallized layer (16) including at least a heavy metal whose atomic mass is greater than or equal to that of copper and silicon, wherein the heavy metal and the silicon of the metallized layer are bonded to the carbonaceous component of the porous body (12) by chemical bonds (18) resulting from the action of intramolecular forces so as to form components that are carbides of metal silicides.

2. Product for removing pollutants from a fluid according to claim 1, wherein the carbides of metal silicides that it includes are components revealed at an energy level approximately equal to 283 eV.

3. Product for removing pollutants from a fluid according to claim 1 or 2, wherein at least part of the silicon (Si) is also bonded to at least part of the heavy metal of the metallized layer (16) by chemical bonds (18) resulting from the action of intramolecular forces.

4. Product for removing pollutants from a fluid according to claim 3, wherein the metallized layer (16) further comprises components including carbon, silicon and heavy metal atoms bonded together by covalent type chemical bonds.

5. Product for removing pollutants from a fluid according to any one of claims 1 to 4, wherein the porous body (12) includes at least one element selected from the group consisting of carbon powder, graphite, activated carbon, sand and zeolite.

6. Product for removing pollutants from a fluid according to any one of claims 1 to 5, wherein the metallized layer (16) partially covers the outer and inner specific surface (14) of the porous body (12) by the formation of aggregates.

7. Method for obtaining a product (10) for removing pollutants from a fluid, comprising a step (102) of treating a porous body (12) including a carbonaceous component and having an outer and inner specific surface (14) in an inert gas plasma deposition reactor (24) with radiofrequency discharge, wherein the deposition reactor (24) is a diode reactor with electrical power approximately equal to 10 kW, coupled to a RLC impedance matching-box, by:
- immersing the porous body (12) into the inert gas plasma with a source of heavy metal whose atomic mass is greater than or equal to that of copper and a source of silicon, then
- injecting the heavy metal and the silicon, in the inert gas plasma, on at least part of the outer and inner specific surface (14) of the porous body (12) by bombarding plasma's inert gas ions onto the sources of heavy metal and silicon, so as to form a metallized layer (16), the thickness of which is at most nanoscale, covering said at least part of the outer and inner specific surface (14) of the porous body (12), the metallized layer (16) thus including, in interaction with the porous body, components that are carbides of metal silicides in which the heavy metal and the silicon of the metallized layer are bonded to the carbonaceous component of the porous body (12) by chemical bonds (18) resulting from the action of intramolecular forces,
wherein the excitation temperature of the plasma is brought to between 5000 K and 7000 K during the treatment step (102).

8. Method for obtaining a product (10) for removing pollutants from a fluid, comprising:
- a preliminary step (100) of functionalizing a porous body (12) including a carbonaceous component and having an outer and inner specific surface (14) in a low pressure fluidized bed reactor (22), notably of between 5 and 500 Pa, with a cold inert gas plasma and with inductive discharge, then
- a step (102) of treating the porous body (12) in an inert gas plasma deposition reactor (24) with radiofrequency discharge, by:
• immersing the porous body (12) into the inert gas plasma with a source of heavy metal whose atomic mass is greater than or equal to that of copper and a source of silicon, then
• injecting the heavy metal and the silicon, in the inert gas plasma, on at least part of the outer and inner specific surface (14) of the porous body (12) by bombarding plasma's inert gas ions onto the sources of heavy metal and silicon, so as to form a metallized layer (16), the thickness of which is at most nanoscale, covering said at least part of the outer and inner specific surface (14) of the porous body (12), the metallized layer (16) thus including, in interaction with the porous body, components that are carbides of metal silicides in which the heavy metal and the silicon of the metallized layer are bonded to the carbonaceous component of the porous body (12) by chemical bonds (18) resulting from the action of intramolecular forces.
